# EUROPÄISCHE PATENTSCHRIFT

(11) **EP 0 565 968 B1**
(45) Veröffentlichungstag und Bekanntmachung des Hinweises auf die Patenterteilung: **25.09.1996**
(21) Anmeldenummer: 93105472.0
(22) Anmeldetag: 02.04.1993
(51) Int. Cl.: H05K 13/00, B65B 13/02, H02G 3/26, H05K 13/06

(54) **Montagegerät zum Festbinden von Kabelbündeln**
Mounting device for attaching cable harnesses
Dispositif de montage pour attacher des faisceaux de câbles

(30) Priorität: 16.04.1992 DE 4212789
(43) Veröffentlichungstag der Anmeldung: 20.10.1993
(73) Patentinhaber: A. Raymond GmbH & Co. KG, D-79539 Lörrach (DE)
(72) Erfinder: Schäfer, Holger, W-7858 Weil/Rhein (DE); Escher, Lothar, W-7841 Bad Bellingen (DE); Büsch, Martin, W-7841 Bamlach (DE)
(74) Vertreter: Kirchgaesser, Johannes, Dipl.-Ing.

(56) Entgegenhaltungen:
- EP-A- 0 297 337
- FR-A- 2 223 141
- US-A- 4 763 700

## Beschreibung

Die Erfindung bezieht sich auf ein Montagegerät zum Festbinden von Kabelbündeln mittels eines mit Querrippen oder Zacken versehenen Kunststoffspannbandes von unbestimmter Länge sowie eines ebenfalls aus Kunststoff hergestellten Verriegelungsschlosses, wobei das durch DE 35 25 351 A1 bekannte Schloß mit einer Öffnung zum Durchführen des Spannbandes und mit zwei mit den Querrippen oder Zacken zusammenwirkenden, einander gegenüberliegenden Rastzungen versehen ist. EP-A-0 297 337 zeigt ein Montagegerät gemäß dem Obergriff von Anspruch 1.

Die Erfindung geht hierbei aus von einem durch die EP 0 303 723 A1 bekannten Montagegerät. Dieses besteht im wesentlichen aus einem Gehäuse mit Aufnahmeteil für das gewickelte Spannband, einer Öffnung zum Aus- und Wiedereintritt des Spannbandes, einem Führungskanal für die Zuführung des Spannbandes zur Öffnung, einem weiteren, oberhalb des Führungskanals angeordneten Kanal für die Zuführung der Verriegelungsschlösser vor die Austrittsöffnung des Spannbandes, sowie einem hinter dem Schloß angeordneten Messer zum Abtrennen der aus dem Verriegelungsschloß vorstehenden Bandenden.

Bei diesem bekannten Montagegerät wird es als Nachteil empfunden, daß die Verriegelungsschlösser auf einer besonderen Stange magaziniert, d.h. aufeinandergestapelt und dann in den oberen Führungskanal eingeschoben werden müssen, um dann mittels Federkraft vorgetrieben und in ein am Gehäuse schwenkbar gelagertes Kopfteil übergeben zu werden, welches jeweils das vordere Schloß vor dem Bandaustritt positioniert.

Ferner ist es unbefriedigend, daß das Spannband direkt von Hand durch den Führungskanal gedrückt und nach dem Umschlingen des Bündels und Einfädeln der Bandspitze im Schloß wieder von Hand zurückgezogen werden muß, bevor das gespannte Band mit dem Messer abgeschnitten werden kann.

Aufgabe der Erfindung ist es daher, das vorgenannte Montagegerät so zu gestalten, daß die durch Haftstege abreißbar miteinander verbundenen Verriegelungsschlösser so, wie sie aus den Spritzgießmaschinen ausgeworfen werden, in das Montagegerät eingelegt und in die Verriegelungsposition befördert werden und daß ferner der Bandtransport durch das Gehäuse bedienungsfreundlicher ausgebildet wird.

Zur Lösung dieser Aufgabe wird gemäß den im Anspruch 1 angegebenen Merkmalen vorgeschlagen, den Führungskanal für die Verriegelungsschlösser zur Bandaustrittsöffnung derart herumzuführen, daß die Schlösser in eine Halteposition vor dem Bandaustritt einführbar sind und den Führungskanal für das Spannband im Gehäuse schwenkbar zu lagern, so daß die Bandaustrittsöffnung in den Schnittbereich des Messers drückbar ist.

Weitere Merkmale der Erfindung gehen aus den Unteransprüchen hervor, wobei im einzelnen folgende Vorteile damit verbunden sind:

Durch Anwendung des Anspruchs 2 wird die Handhabung wesentlich erleichtert, indem das gerändelte Rad mit dem Zeigefinger der gleichen Hand betätigt werden kann, die auch das Montagegerät hält. So bleibt die andere Hand frei für das Umschlingen des Bündels mit dem Band und zum Einfädeln des Bandendes in das Verriegelungsschloß.

Durch die schwenkbar gelagerte Klinke gemäß Anspruch 3 wird die positionsgenaue Lage des Schlosses vor der Bandaustrittsöffnung während des Durchführens des Bandes und des Einrastens des Bandendes nach dem Umschlingen des Bündels sichergestellt und durch die Maßnahmen nach Anspruch 4 wird das Niederdrücken des Führungskanals am Ende der Umschlingungsoperation erleichtert, wobei der seitlich abstehende Stift praktisch vom Daumen der das Gerät haltenden Hand betätigt werden kann.

In der Zeichnung ist ein Ausführungsbeispiel der Erfindung dargestellt und soll nachfolgend näher erläutert werden. Es zeigt
- Fig. 1: ein Montagegerät in Vorderansicht,
- Fig. 2: das Gerät in Seitenansicht mit Blick auf den Bandaustritt,
- Fig. 3: ein Längsschnitt durch das Gerät gemäß Linie III - III in Figur 2,
- Fig. 4: ein Querschnitt durch das Gerät gemäß Linie IV - IV in Figur 3,
- Fig. 5: ein Längsschnitt wie Figur 3 mit eingelegtem Spannband und Verriegelungsschlössern vor dem Umspannen eines Kabelbündels,
- Fig. 6: das Montagegerät nach Figur 5 nach dem Umspannen des Kabelbündels und
- Fig. 7: das Montagegerät beim Abdrücken des Spannbandes.

Das in den Figuren dargestellte Montagegerät dient zum Festbinden von Kabelbündeln mittels eines endlosen Kunststoffspannbandes in Verbindung mit Verriegelungsschlössern, die ebenfalls aus hartelastischem Kunststoff hergestellt sind. Die beispielsweise in DE 35 25 351 A1 beschriebenen Spannbänder sind mit Querrippen oder Zacken versehen und werden durch die Öffnung im Verriegelungsschloß zunächst von der einen Seite hindurchgeführt und nach dem Umspannen des Kabelbündels von der anderen Seite in die gleiche Öffnung zurückgesteckt. In der Öffnung befinden sich zwei einander gegenüberliegende, auffederbare Rastzungen, die mit den Querrippen des Spannbandes zusammenwirken.

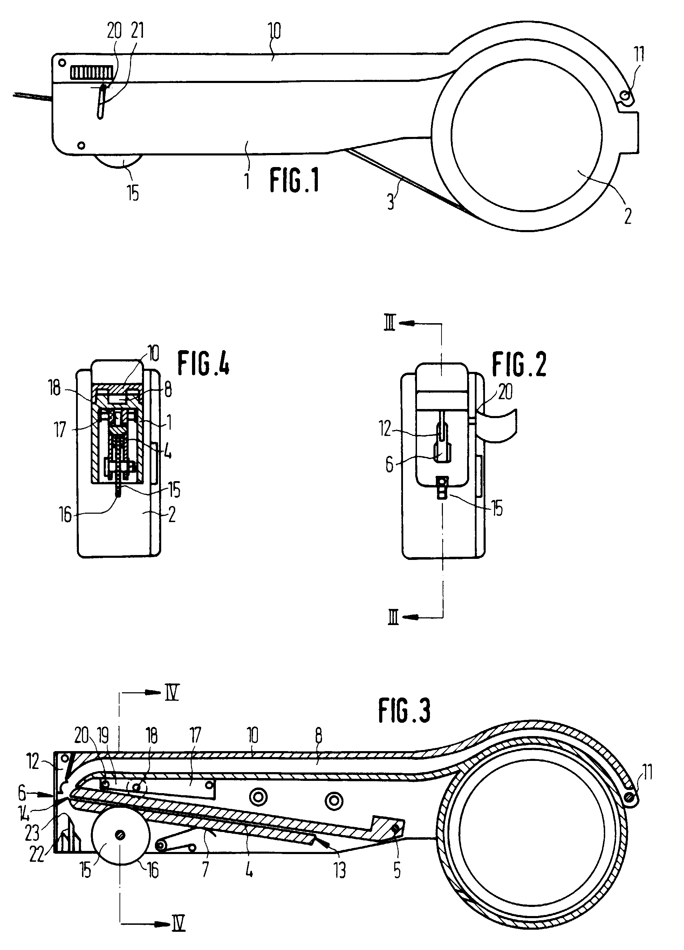

Das Montagegerät besteht aus einem handlichen Gehäuse 1 mit einem Aufnahmeteil 2 für das aufgewickelte Spannband 3. Wie aus dem Längsschnitt gemäß Figur 3 ersichtlich, ist im Gehäuseinnern ein Führungskanal 4 für das Spannband 3 vorgesehen, welcher vor seinem Eintrittsende 13 bei 5 schwenkbar im Gehäuse 1 gelagert und mit seiner Austrittsöffnung 14 auf eine Gehäuseöffnung 6 gerichtet ist. Der Führungskanal 4 wird mittels einer Feder 7 in der oberen Position gehalten.

Oberhalb dieses Führungskanals 4 ist ein weiterer Kanal 8 angeordnet, welcher zur Aufnahme der Verriegelungsschlösser 9 ausgebildet ist. Der Kanal 8 ist von oben mit einer Abdeckrinne 10 verschließbar, welche bei 11 schwenkbar mit dem Gehäuse 1 verbunden und am vorderen Ende durch einen nicht näher dargestellten Einrastmechanismus verschließbar ist.

Ebenfalls am vorderen Ende der Abdeckrinne 10 befindet sich eine schwenkbar gelagerte Klinke 12, welche mit Federkraft gegen den jeweils oberen Lochrand des gerade vor dem Führungskanal 4 befindlichen Schlosses 9 angedrückt wird.

Der Kanal 8 ist zum Austrittsende des Führungskanals 4 derart herumgeführt, daß die Schlösser 9, welche durch Haftstege abreißbar miteinander verbunden sind, mit ihrer Öffnung direkt in die Halteposition vor der Bandaustrittsöffnung 14 des Führungskanals 4 einsetzbar sind.

Das Spannband 3 wird mittels einer von Hand drehbaren Rolle 15 vorgetrieben, welche an ihrer Umfangsfläche 16, gerändelt ist und mit dieser gegen das gezackte Spannband 3 andrückbar ist. Die Rolle 15 befindet sich unterhalb des Führungskanals 4 kurz vor der Bandaustrittsöffnung 14 und steht mit einem Teil seiner Umfangsfläche 16 aus dem Gehäuse 1 vor, so daß die Rolle 15 leicht mit dem Zeigefinger der Hand, die das Montagegerät hält, gedreht werden kann.

Oberhalb des schwenkbaren Führungskanals 4 ist ein Hebel 17 im Gehäuse 1 schwenkbar gelagert. Dieser Hebel 17 trägt in seinem vorderen Drittel eine drehbar gelagerte Rolle 18, welche auf dem vorderen Bereich des Führungskanals 4 aufliegt. Der Hebel 17 ist noch etwas über die Rollenlagerung verlängert und besitzt an seinem Ende 19 einen seitlich abstehenden Stift 20, welcher in einem bogenförmigen Langloch 21 aus dem Gehäuse seitlich versteht und von Hand gegen die Kraft der Feder 7 niederdrückbar ist.

Unterhalb des Bandaustritts 14 ist im Gehäuse 1 ein Messer 22 angeordnet, das mit seiner Schneide 23 auf das Spannband gerichtet ist. Beim Abwärtsdrücken des schwenkbaren Führungskanals 4 wird das Spannband 3 auf die Schneide 23 gedrückt und genau zwischen Bandaustritt 14 und Verriegelungsschloß 9 abgeschnitten, welches vom Band 3 mit heruntergezogen wird.

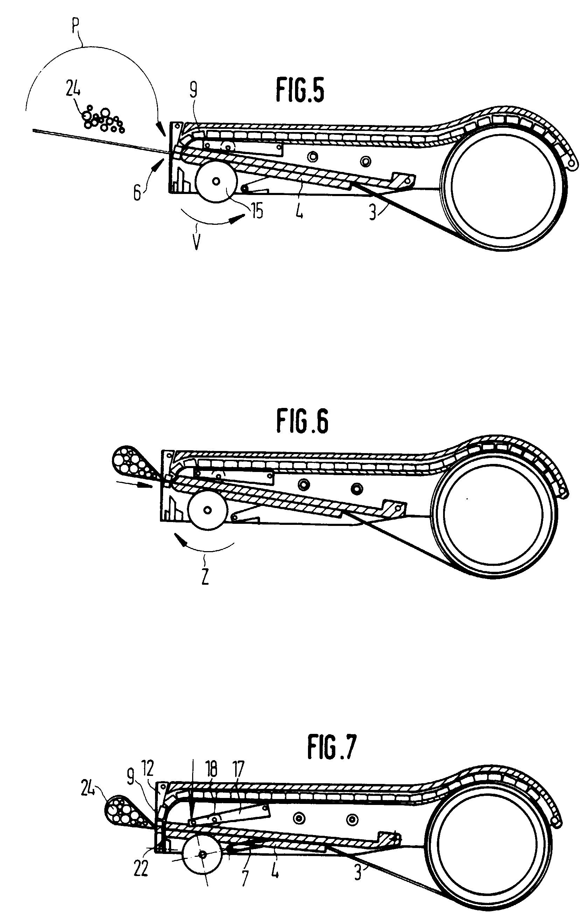

Die Arbeitsweise mit dem Montagegerät ist in den Figuren 5 bis 7 anschaulich dargestellt.

Bei der ersten Arbeitsposition befindet sich das Montagegerät, welches mit einer Spannbandrolle 3 und kettenförmig zusammenhängenden Schlössern 9 beladen ist, mit seiner Öffnung 6 vor einem Kabelbündel 24.

Durch Drehen der gerändelten Rolle 15 in Pfeilrichtung "V" wird das Spannband 3 vorgetrieben. Dann wird mit der freien Hand das Ende des Spannbandes 3 um das Bündel 24 in Richtung des Pfeiles "P" herumgeführt und von der anderen Seite in die Öffnung des Verriegelungsschlosses 9 wieder eingefädelt und so weit eingedrückt, bis mindestens eine Querrippe von der Rastzunge erfaßt ist.
Sodann wird das Band 3 durch Drehen der Rolle in Pfeilrichtung "Z", wie aus Figur 6 ersichtlich, wieder zurückgezogen und um das Bündel 24 gespannt.
Nun ist der Bindevorgang beendet und der Führungskanal 4 wird über den Hebel 17 und die Andrückrolle 18 nach unten gedrückt, wobei das aus dem Schloß 9 vorstehende Bandende auf die Scheide 23 des Messers 22 trifft und dabei abgeschnitten wird (Figur 7). Durch das Niederdrücken des Schlosses 9 ist das über Haftstege verbundene, nachfolgende Schloß 9 gleichzeitig in seine Arbeitsposition gezogen worden und wird von der Klinke 12 in dieser Position für den nächsten Bindevorgang fixiert.

## Patentansprüche

1. Montagegerät zum Festbinden von Kabelbündeln mittels eines mit Querrippen oder Zacken versehenen Kunststoffspannbandes (3) von unbestimmter Länge sowie eines ebenfalls aus Kunststoff hergestellten, separaten Verriegelungsschlosses (9) mit einer Öffnung zum Durchführen des Spannbandes und mit zwei mit den Querrippen oder Zacken zusammenwirkenden, einander gegenüberliegenden Rastzungen, wobei das Montagegerät aus folgenden Funktionsteilen besteht:
- einem Gehäuse (1) mit Aufnahmeteil (2) für das gewickelte Spannband (3),
- einer Öffnung (6) zum Aus- und Wiedereintritt des Spannbandes (3),
- einem Führungskanal (4) für die Zuführung des Spannbandes (3) zur Öffnung (6),
- einem weiteren, oberhalb des Führungskanals (4) angeordneten Kanal (8) für die Zuführung der Verriegelungsschlösser (9) vor die Austrittsöffnung (14) des Spannbandes (3), sowie
- einem hinter dem Schloß (9) angeordneten Messer (22) zum Abtrennen der aus dem Verriegelungsschloß (9) vorstehenden Bandenden,
**dadurch gekennzeichnet,** daß
- der Führungskanal (8) für die Verriegelungsschlösser (9) zur Bandaustrittsöffnung (14) derart herumgeführt ist, daß die durch Haftstege abreißbar miteinander verbundenen Schlösser (9) jeweils mit ihrer Öffnung in eine Halteposition vor der Bandaustrittsöffnung (14) hineinziehbar sind und
- der Führungskanal (4) für das Spannband (3) vor seinem Eintrittsende (13) im Gehäuse (1) schwenkbar gelagert ist, so daß die Bandaustrittsöffnung (14) in den Schnittbereich (23) des Messers (22) drückbar ist, wobei durch das Miederdrücken das über Haftstege verbundene, nachfolgende Schloß in seine Halteposition heruntergezogen wird.

2. Montagegerät nach Anspruch 1, dadurch gekennzeichnet, daß unterhalb des schwenkbaren Führungskanals (4) vor der Bandaustrittsöffnung (14) eine von Hand drehbare Rolle (15) aus dem Gehäuse (1) vorsteht, welche an ihrer Umfangsfläche gerändelt und mit dieser Fläche gegen das gezackte Spannband (3) andrückbar ist.

3. Montagegerät nach Anspruch 1 oder 2, dadurch gekennzeichnet, daß oberhalb des Führungskanals (4) eine im Gehäuse (1) schwenkbar gelagerte Klinke (12) zum Festhalten des jeweils vor der Bandaustrittsöffnung (14) befindlichen Schlosses (9) vorgesehen ist.

4. Montagegerät nach einem der Ansprüche 1 bis 3, dadurch gekennzeichnet, daß der schwenkbare Führungskanal (4) oberhalb vor der Bandaustrittsöffnung (14) durch eine im Gehäuse (1) schwenkbar gelagerte Rolle (18) niederdrückbar ist, welche in einem schwenkbaren Hebel (17) gelagert ist, dessen Ende (19) über die Rolle (18) hinausragt und über einen aus dem Gehäuse (1) seitlich abstehenden Stift (20) von Hand zu betätigen ist.

## Claims

1. A mounting device for tying cable harnesses by means of a plastics clamping band (3) of indeterminate length which is provided with transverse ribs or prongs and a separate locking fastener (9) also produced from plastics material and having an opening for passing the clamping band therethrough and two mutually oppositely disposed retaining tongues which co-operate with the transverse ribs or prongs, wherein the mounting device comprises the following functional parts:
- a housing (1) with receiving portion (2) for the wound clamping band (3),
- an opening (6) for the exit and re-entry of the clamping band (3),
- a guide passage (4) for feeding the clamping band (3) to the opening (6),
- a further passage (8) arranged above the guide passage (4) for feeding the locking fasteners (9) to a position in front of the exit opening (14) for the clamping band (3), and
- a blade (22) arranged behind the fastener (9) for cutting off the band ends projecting out of the locking fastener (9),
characterised in that
- the guide passage (8) for the locking fasteners (9) is guided around to the band exit opening (14) in such a way that the fasteners (9) which are connected together by adhesive webs in such a way that they can be torn off can each be pulled with their respective opening into a holding position in front of the band exit opening (14), and
- the guide passage (4) for the clamping band (3) is mounted pivotably in the housing (1) in front of its entry end (13) so that the band exit opening (14) can be pressed into the cutting region (23) of the blade (22), wherein the following fastener which is connected by way of adhesive webs is pulled down into its holding position by the depression movement.

2. A mounting device according to claim 1 characterised in that a roller (15) which is rotatable by hand projects out of the housing (1) beneath the pivotable guide passage (4) in front of the band exit opening (14), which roller is knurled at its peripheral surface and can be pressed with said surface against the pronged clamping band (3).

3. A mounting device according to claim 1 or claim 2 characterised in that provided above the guide passage (4) is a pawl (12) which is mounted pivotably in the housing (1) for holding fast the respective fastener (9) which is disposed in front of the band exit opening (14).

4. A mounting device according to one of claims 1 to 3 characterised in that the pivotable guide passage (4) can be depressed above in front of the band exit opening (14) by a roller (18) which is mounted pivotably in the housing (1) and which is mounted in a pivotable lever (17) whose end (19) projects beyond the roller (18) and is to be actuated by hand by way of a pin (20) which projects laterally out of the housing (1).

## Revendications

1. Dispositif de montage pour attacher des faisceaux de câbles par l'intermédiaire d'une lanière de serrage en matière plastique munie de nervures obliques ou de crans (3) d'une longueur indéterminée ainsi que d'une boucle de verrouillage séparée (9) également réalisée en matière plastique, comportant une ouverture pour le passage de la lanière de serrage et deux languettes d'encliquetage diamétralement opposées venant en prise d'encastrement avec les nervures obliques ou les crans, le dispositif de montage se composant en l'occurrence des pièces fonctionnelles suivantes:
- un boîtier (1) comportant une partie formant logement (2) pour la lanière de serrage enroulée (3)
- une ouverture (6) pour le dégagement et la réintroduction de la lanière de serrage (3),
- un canal de guidage (4) pour l'introduction de la lanière de serrage (3) dans l'ouverture (6),
- un autre canal (8) disposé au-dessus du canal de guidage (4) pour l'amenée des boucles de verrouillage (9) devant l'ouverture de sortie (14) de la lanière de serrage (3) et
- un couteau (22) disposé derrière la boucle (9) pour le tronçonnage des extrémités de lanière dépassant de la boucle de verrouillage (9), **caractérisé en ce que**
- le canal de guidage (8) des boucles de verrouillage (9) vers l'ouverture de sortie de la lanière (14) a un tracé recourbé tel que les boucles (9), successivement reliées l'une à l'autre par des barrettes de liaison arrachables, peuvent être respectivement amenées avec leur ouverture dans une position de maintien devant l'ouverture de sortie de la lanière (14) et que
- le canal de guidage (4) de la lanière de serrage (3) est disposé pivotant devant son extrémité d'entrée (13) dans le boîtier (1) dans des conditions telles que l'ouverture de sortie de la lanière (14) peut être poussée dans la zone de coupe (23) du couteau (22), ce qui fait que, par cet effet d'abaissement, la boucle suivante reliée par une languette de liaison est tirée vers le bas dans sa position de maintien.

2. Dispositif de montage selon la revendication 1, caractérisé en ce qu'en-dessous du canal de guidage pivotant (4), devant l'ouverture de sortie de la lanière (14), un rouleau (15) actionnable à la main fait saillie du boîtier (1), qui est moleté sur la périphérie et qui est destiné à être appliqué au niveau de cette face contre la lanière de serrage crantée (3).

3. Dispositif de montage selon la revendication 1 ou 2, caractérisé en ce qu'il est prévu au-dessus du canal de guidage (4) un cliquet (12) monté pivotant dans le boîtier (1) pour immobiliser en position la boucle (9) se trouvant respectivement devant l'ouverture de sortie de la lanière (14).

4. Dispositif de montage selon une des revendications 1 à 3, caractérisé en ce que le canal de guidage pivotant (4) peut être pressé au-dessus de l'ouverture de sortie de la lanière (14) par un galet (18) disposé pivotant dans le boîtier (1), qui est monté dans un levier pivotant (17), dont l'extrémité (19) fait saillie au-dessus du galet (18) et doit être actionné à la main par l'intermédiaire d'une tige (20) sortant latéralement du boîtier (1).
